# EUROPEAN PATENT APPLICATION

(11) **EP 4 756 504 A1**
(43) Date of publication of application: **10.06.2026**
(21) Application number: 24217376.3
(22) Date of filing: 04.12.2024
(51) Int. Cl.: G02B 6/12, G02F 1/017, G02B 6/293, H01S 5/10

(54) **AN OPTICAL RING RESONATOR AND AN OPTICAL INTERCONNECT SYSTEM**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

The disclosure relates to an optical ring resonator comprising: a substrate; a ring element arranged on the substrate, the ring element comprising: a core ring having a p-doped GaN crystal structure, and a ring-shaped embedding shell having an n-doped GaN crystal structure, the ring-shaped embedding shell embedding the core ring both on a radially inward side and a radially outward side thereof. An optical interconnect system is further disclosed.

## Description

### Technical field of the invention

The present disclosure relates to optical ring resonators. More specifically, the disclosure relates to an optical ring resonator and an optical interconnect system as defined in the introductory parts of the independent claims.

### Background to the invention

Optical ring resonators are fundamental components in the field of photonics, where they serve as compact devices for filtering, modulating, and detecting optical signals. Their design and function leverage the principle of optical resonance, making them suitable for applications across telecommunications, sensing, quantum computing, and biomedical devices. Typically fabricated from high-refractive-index materials such as silicon or silicon nitride, optical ring resonators can confine light within a small, circular waveguide, enabling high-quality optical signals in a miniaturized format.

The working principle of an optical ring resonator is based on the resonant enhancement of specific wavelengths of light. An optical ring resonator may be understood as a circular waveguide which could be positioned close to another waveguide, e.g. a straight waveguide structure, creating an evanescent coupling region. In more detail, when light travels along the straight waveguide, a portion of the light may be coupled into the ring to circulate within it. For certain resonant wavelengths, where the optical path length around the ring matches an integer multiple of the wavelength, constructive interference occurs, and the light intensity within the ring is significantly enhanced. The resonant modes arising in optical ring resonator may in some examples be referred to as whispering gallery modes. The resonant wavelengths can be controlled by adjusting the radius of the ring or the refractive index of the material, enabling precise tuning of the optical properties.

Optical ring resonators are versatile due to their compact footprint and compatibility with standard micro and nanofabrication processes. The integration of optical ring resonators for example into silicon photonic chips allows for large-scale, low-cost production, making them highly appealing for commercial applications.

Today's optical ring resonators, however, may face limitations. One major challenge is to achieve the required fabrication precision for high performance operation, i.e. to achieve the necessary nanoscale accuracy. Thermal sensitivity is another issue, as temperature fluctuations can affect the refractive index and, consequently, the resonator's performance. Additionally, light losses, e.g. due to scattering and absorption may degrade the quality factor, Q-factor, of the resonator, limiting its efficiency which may hinder high speed performance. To this end, integration with other photonic components can be challenging, especially when trying to maintain compactness and high performance. Hence, there is a need for improved optical ring resonators and systems of optical ring resonators.

### Summary of the invention

It is an object of the present disclosure to mitigate, alleviate or eliminate one or more of the above-identified deficiencies and disadvantages in the prior art and solve at least the above-mentioned problems and shortcomings. It is an objective of the present inventive concept to enable more efficient optical ring resonators and systems of such optical ring resonators. It is further an objective to provide optical ring resonators with improved tunability and reduced footprint. Another object is to obtain optical ring resonators that can operate at higher speeds. Preferred examples are set out in the dependent claims.

In this text abbreviations of the natural elements will be used in accordance with the periodic table. For example, Al means aluminum, Ga means gallium, N means nitrogen, Si means silicon, In means indium, C means carbon.

According to a first aspect there is provided an optical ring resonator comprising: a substrate; a ring element arranged on the substrate, the ring element comprising: a core ring having a p-doped GaN crystal structure, and a ring-shaped embedding shell having an n-doped GaN crystal structure, the ring-shaped embedding shell embedding the core ring both on a radially inward side and a radially outward side thereof.

An advantage may be that a more versatile optical ring resonator is provided. The versatility may allow for a larger range of applications, such as biochemical sensing, telecommunications, and environmental monitoring. A further advantage may be that a higher sensitivity of the optical ring resonator may be achieved.

The ring structure may further allow for a reduced footprint. A higher density of optical ring resonators may thereby be provided. To this end, photonic circuits comprising a plurality of optical ring resonators may be used in circuit design. Smaller and denser electronic and/or photonic circuits may thereby be obtained.

An additional advantage of the optical ring resonator may be that multiple signals may be propagating simultaneously, which may be beneficial for high data throughput. The optical ring resonator may further consume less power, enhancing energy efficiency. A higher quality factor, Q-factor, may further be provided by the ring structure allowing for storing of energy for longer periods. This may be advantageous for improved filtering and signal processing.

An advantage of having a core ring having a p-doped GaN crystal structure and a ring-shaped embedding shell having an n-doped GaN crystal structure is that a pn junction may be provided within the ring element. Put differently, the structure of the ring element allows for an optical resonator channel to be formed by the pn junction. An advantage may be that the pn junction may allow for active modulation of the optical signal. This as the pn junction may be biased with different bias voltages. In other words, a bias voltage may be applied to the optical resonator ring, e.g. via electrodes attached to the respective p- and n-doped GaN crystal structures, such that the pn junction is forward or reverse biased. The biasing may further allow for improved control of the refractive index and absorption properties of the optical ring resonator. A more precise tuning of the resonator's characteristics may thereby be provided. The pn junction may further facilitate light generation and amplification within the ring element. In more detail, the optical ring resonator may take advantage of processes such as electroluminescence and stimulated emission for creating enhanced propagation efficiency. Additionally, the pn junction may enhance carrier confinement, improving the interaction between light and the semiconductor material. An increased quality of optical signals may thereby be provided.

An advantage of having a p-type core ring with an n-type ring-shaped embedding shell is that a double vertical pn junction structure is provided. Put differently, a concentric pn junction is formed at the inner and outer interfaces of the core ring. In other words, a first pn junction is formed at the inner interface and a second pn junction is formed at the outer interface. The first and the second pn junctions may be understood as concentric rings or concentric channels. A smaller footprint for the optical ring resonator may thereby be obtained.

A further advantage of having concentric channels, i.e. the pn junctions for light propagation, is that an enhanced light coupling efficiency between the two channels may be provided. An improved performance of the optical ring resonator may be obtained. The structure of the optical ring resonator may further allow for an improved control of the resonance characteristics of resonator, enabling more precise tuning and filtering capabilities.

According to some examples, the ring element further comprises an intermediate shell arranged in between the core ring and the ring-shaped embedding shell, the intermediate shell comprises a quantum well layer made of a semiconductor material having a lower bandgap than GaN.

An advantage of having a quantum well, QW, layer within the pn junction is that an enhanced performance of the optical ring resonator may be achieved. Quantum wells increase the confinement of charge carriers, such as electrons and holes, within a layer inside the pn-junction. As a result, the probability of recombination between electrons and holes is increased. To this end the probability of recombination of charge carriers may be tuned by the biasing of the pn junction. By way of example, the recombination may be increased by forward biasing the pn junction. This confinement of charge carriers may lead to a more efficient light emission and amplification. A further advantage is that the quantum confinement effect provided by the quantum wells may allow for better control over the emission wavelength and improves the modulation capability and/or speed of the optical ring resonator. Put differently, the control over the light properties of the optical ring resonator may be improved.

According to some examples, the quantum well layer is made from In(x)Ga(1-x)N, wherein the In content, x, is in a range 0.1 ≤ x ≤ 0.75.

An advantage may be that a quantum well layer is obtained allowing for efficient capture of charge carriers. An improved light generation may be achieved. The In content may further be tuned within the range to match light generation/propagation at wavelength in the range of 420 to 440 nm.

According to some examples, the quantum well layer has a thickness of ≤ 5 nm.

An advantage being that a stronger confinement of charge carriers may be obtained within the quantum well layer.

According to some examples, the intermediate shell comprises a plurality of a quantum well layers, each being made of a semiconductor material having a lower bandgap than GaN. The quantum well layers may be separated by GaN layers. Put differently, a plurality of quantum well layers are provided, wherein the individual quantum well layers are separated by GaN layers.

An advantage being that a multi quantum well structure, MQW structure, may be provided. A more efficient light emission and amplification may be achieved within the ring element. The semiconductor material or composition thereof may be the same or different for the individual quantum wells in the multi quantum well structure.

According to some examples, the intermediate shell further comprises a first and a second barrier layer arranged on opposite sides of the quantum well layer in a radial extension of the ring element.

An advantage being that an improved confinement of charge carriers, such as electrons and holes, within the quantum well, is provided. The first and the second barrier layers may be understood as material layers having a higher bandgap than the material of the quantum well layer and the GaN. Hence, the barrier layers may reduce leakage of charge carriers from the quantum well layer. The first and the second barrier layers may further improve the isolation of the quantum wells from external influences, such as impurities or defects, which may degrade the performance.

According to some examples, barrier layers may be provided on opposite sides of a multi quantum well structure.

According to some examples, the first and second barrier layers are made from an AI(y)Ga(1-y)N, wherein the Al content, y, is in a range of 0.1 ≤ y ≤ 1.

The thickness and composition of the first and the second barrier layers may thereby be adjusted to control the quantum states and energy levels within the quantum well. The Al content may differ between the first and the second barrier layer.

According to some examples, each quantum well of a plurality of quantum well layers may be sandwiched between a pair of barrier layers.

According to some examples, the first and second barrier layers has a thickness of ≤ 10 nm.

An advantage may be that a more uniform carrier distribution may be provided within the ring element.

By way of example, in case of a plurality of quantum well layers of the device the carrier distribution between the quantum wells may be improved. The thinner barrier layers may improve the performance of the quantum well or quantum wells such that an improved optical performance is achieved, including enhanced electroluminescence intensity output, reducing variations in emission wavelength, and improved energy efficiency when the optical ring resonator is electrically driven.

According to some examples, the intermediate shell further comprises first and second intrinsic layers arranged on opposite sides of the quantum well layer in a radial extension of the ring element and forming outermost layers of the intermediate shell, wherein the first and second intrinsic layers are made by undoped GaN.

The undoped GaN may be referred to as an undoped GaN crystal structure.

An advantage may be that the first and second intrinsic layers further improve performance of the optical ring resonator. By way of example, the a higher-speed operation may be provided due to reduced capacitance. Enhanced photon absorption and better carrier collection may also be achieved with the effectively wider depletion region. To this end, higher power handling capabilities, and reduced noise for applications requiring high signal-to-noise ratios may be obtained.

According to some examples, a centrum radius of the ring element is 1-10 micrometer.

An advantage being that a smaller footprint may be obtained.

According to some examples, the optical ring resonator further comprises a superlattice structure comprising alternating layers of AlGaN and GaN.

An advantage may be that the leakage of light from the ring element may be reduced. A more efficient optical ring resonator may thereby be achieved. The superlattice structure may be understood as a Bragg reflector or distributed Bragg reflector. The multiple layers of alternating materials, i.e. AlGaN and GaN having different refractive indices may cause constructive interference for specific wavelengths of light, which results in high reflectivity for those wavelengths. The thicknesses of the respective layers may be set to tune the wavelengths at which the constructive interference occurs.

The superlattice structure may be arranged on a top portion of the optical ring resonator. The superlattice may extend in a plane parallel to the substrate. Alternately or in combination, the superlattice structure may be arranged between the substrate and the ring element.

According to a second aspect there is provided an optical interconnect system. The optical interconnect system comprising:
a first optical ring resonator as described above, the first optical ring resonator forming part of a first electrical circuit;
a second optical ring resonator as described above, the second optical ring resonator forming part of a second electrical circuit; and
a bus waveguide having a GaN semiconductor core for transmission of light, the bus waveguide comprising coupling regions for forming an optical connection with the first and second optical ring resonators, respectively.

An advantage may be that a more efficient transmission of light between the optical ring resonators may be achieved. To this end, a reduced leakage of light from the GaN semiconductor core may be achieved.

According to some examples, the optical interconnect system further comprising a respective grating coupler arranged at the respective coupling regions.

The bus waveguide may thereby more efficiently couple light into and out of the optical ring resonators. The bus waveguide may be arranged to run tangentially to the optical ring resonators, allowing light to transfer between the bus waveguide and the optical ring resonators through evanescent coupling. The grating coupler further allows for scattering of light improving the coupling efficiency within the respective coupling regions.

According to some examples, a distance between a periphery of the first and second optical ring resonators, respectively, and the bus waveguide is less than 1 micron.

An efficient light transfer between the bus waveguide and the optical ring resonators may thereby be achieved.

According to some examples, the first electrical circuit comprises a transmitter configured to generate a modulated light signal based on an electrical input signal and injecting the modulated light signal into the first optical ring resonator,
wherein the second electrical circuit comprises a receiver configured to receive a modulated light signal from the second optical ring resonator and based thereon generate an electrical output signal.

An advantage maybe that information may be efficiently transferred between the two electrical circuits. By way of example, information transfer may be achieved by the transmitter being arranged by sending light into the first optical ring resonator. Alternatively, or in combination the transmitter may be arranged to apply an external electric field on to at least a portion of the ring element of the first optical ring resonator, which may change the carrier density within the ring element. By way of example, the pn junction may be biased. The applied external electric field may induce a change in the refractive index via the plasma dispersion effect, thereby shifting the resonance wavelength of the optical ring resonator. The shift in resonance wavelength may be used to modulate the intensity of the light passing through the ring element, effectively encoding the signal.

The received modulated light signal from the second optical ring resonator may be the same or different to the modulated light signal from the transmitter. By way of example, the modulated light signal may be attenuated due to leakage of light. In other words, the transmitter may be configured to generate a first modulated light signal based on an electrical input signal and injecting the first modulated light signal into the first optical ring resonator, wherein the second electrical circuit comprises a receiver configured to receive a second modulated light signal from the second optical ring resonator and based thereon generate an electrical output signal.

The bus waveguide having a GaN semiconductor core may provide transmission of the light signal between the first and second optical ring resonators.

According to some examples, the first optical ring resonator is arranged on a first semiconductor die,
the second optical ring resonator is arranged on a second semiconductor die,
a portion of the first electrical circuit is arranged on a third semiconductor die,
a portion of the second electrical circuit is arranged on a fourth semiconductor die,
the first semiconductor die is electrically connected to the third semiconductor die for forming the first electrical circuit, and
the second semiconductor die is electrically connected to the fourth semiconductor die for forming the second electrical circuit.

An advantage may be that the integration of optical ring resonators for example into silicon photonic chips may be simplified. More compact integrated optical systems may moreover be provided. A stacking of optical ring resonators on different dies allows for increased modularity and large-scale, low-cost production.

Effects and features of the second aspect are to a large extent analogous to those described above in connection with the first aspect. Examples mentioned in relation to the first aspect are largely compatible with the second aspect.

The present disclosure will become apparent from the detailed description given below. The detailed description and specific examples disclose preferred examples of the disclosure by way of illustration only. Those skilled in the art understand from guidance in the detailed description that changes and modifications may be made within the scope of the disclosure.

Hence, it is to be understood that the herein disclosed disclosure is not limited to the particular component parts of the device described or steps of the methods described since such device and method may vary. It is also to be understood that the terminology used herein is for purpose of describing particular examples only, and is not intended to be limiting. It should be noted that, as used in the specification and the appended claim, the articles "a", "an", "the", and "said" are intended to mean that there are one or more of the elements unless the context explicitly dictates otherwise. Thus, for example, reference to "a unit" or "the unit" may include several devices, and the like. Furthermore, the words "comprising", "including", "containing" and similar wordings does not exclude other elements or steps.

### Brief descriptions of the drawings

The above objects, as well as additional objects, features and advantages of the present disclosure, will be more fully appreciated by reference to the following illustrative and non-limiting detailed description of examples of the present disclosure, when taken in conjunction with the accompanying drawings.
Figure 1a shows schematically a top view of the optical ring resonator according to some examples.
Figure 1b shows the optical ring resonator of Figure 1a from a cross sectional view.
Figure 1c illustrates schematically an energy band structure diagram along the radial direction of the ring element of Figures 1a and 1b.
Figure 2a shows schematically a top view of another optical ring resonator according to some examples.
Figure 2b shows the optical ring resonator of Figure 2a from a cross sectional view.
Figure 2c illustrates schematically a band structure diagram across the radial direction of the ring element of Figures 2a and 2b.
Figure 3a shows schematically a top view of yet another optical ring resonator according to some examples.
Figure 3b shows the optical ring resonator of Figure 3a from a cross sectional view.
Figure 3c illustrates schematically an energy band structure diagram across the radial direction of the ring element of Figures 3a and 3b.
Figure 4 shows schematically a top view of yet another optical ring resonator according to some examples.
Figure 4b shows the optical ring resonator of Figure 4a from a cross sectional view.
Figure 4c illustrates schematically a band structure diagram across the radial direction of the ring element of Figures 4a and 4b.
Figure 5a illustrates an optical ring oscillator according to some examples.
Figure 5b illustrates an optical ring oscillator according to some examples.
Figure 6 illustrates an optical interconnect system according to some examples.
Figure 7 illustrates an optical interconnect system according to some examples.

### Detailed description

The present disclosure will now be described with reference to the accompanying drawings, in which preferred examples of the disclosure are shown. The disclosure may, however, be embodied in other forms and should not be construed as limited to the herein disclosed examples. The disclosed examples are provided to fully convey the scope of the disclosure to the skilled person.

The first aspect of this disclosure relates to an optical ring resonator. The optical ring resonator comprises a substrate and a ring element arranged on the substrate.

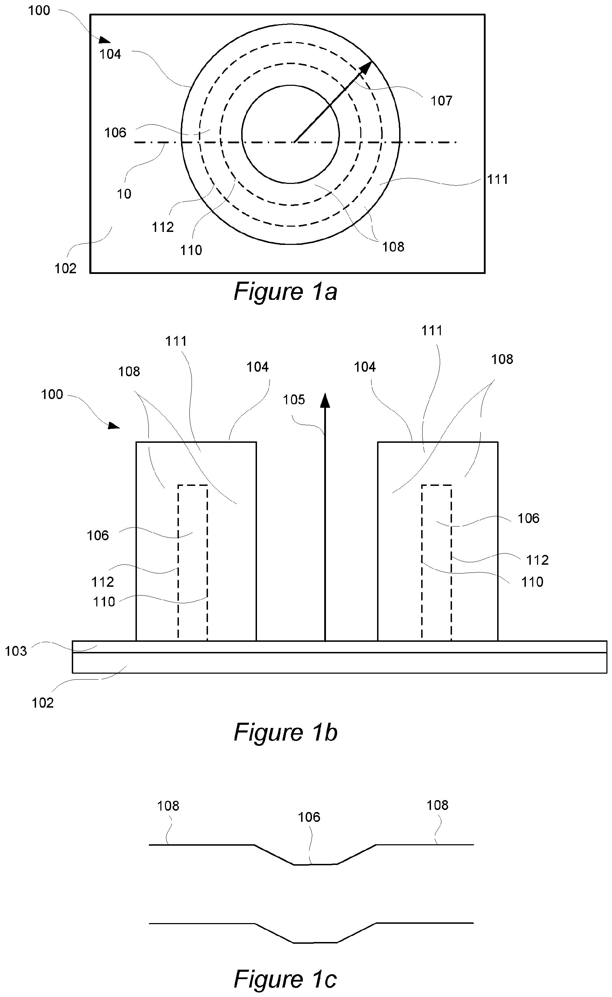

Figure 1a shows schematically a top view of the optical ring resonator according to some examples. Figure 1b shows the same optical ring resonator from a cross sectional view and Figure 1c illustrates schematically an energy band structure diagram along the radial direction of the ring element. The dash-dotted line 10 in Figure 1a illustrates the cross section.

In more detail and with reference with the Figures 1a to 1b, the optical ring resonator 100 is shown to comprise a substrate 102 and a ring element 104 arranged on the substrate 102.

The optical ring resonator 100 may comprise an additional semiconductor layer or additional semiconductor layers, as illustrated by the layer 103. By way of example, the additional semiconductor layer may be a GaN layer arranged on the substrate 102.

The ring element 104 may be grown on the substrate 102. The substrate 102 may be a Si substrate. The substrate 102 may be a silicon substrate. The silicon substrate may be a Si <111> substrate. The silicon substrate may comprise a GaN layer. The GaN layer may be arranged on the substrate. The substrate may comprise a strain relaxation layer on which the GaN layer is grown. The strain relaxation layer may be formed by one or more AlGaN or AIN layers. One or more AIN layers may form a buffer layer. The AlGaN layer may be formed by a stack of AlGaN layers. The stack of AlGaN layers may form a graded buffer layer. The stack of AlGaN layers may be arranged on the AIN buffer layer.

According to other examples, the substrate 102 may be e.g. a SiC, or sapphire substrate.

The optical ring resonator 100 may be formed by epitaxial growth, e.g. by MOVPE, on the substrate 102. The semiconductor layers grown on top of the substrate 102 may be doped, with n-type, or p-type dopants, during epitaxial growth. The semiconductor layers may be further doped, e.g. in certain regions, after epitaxial growth. Certain regions may e.g. be doped through diffusion from a gas phase or through ion implantation.

The ring element 104 comprises a core ring 106 having a p-doped GaN crystal structure and a ring-shaped embedding shell 108 having a n-doped GaN crystal structure. The ring-shaped embedding shell 108 embeds the core ring 106 both on a radially inward side 110 and a radially outward side 112 thereof, see Figures 1a and 1b.

The ring element 104 may extend in a vertical direction 105, see Figure 1b. The wording "vertical direction" may be understood as in a direction being perpendicular to the surface of the substrate 102. The vertical direction 105 may be parallel to the surface normal of the substrate 102. The optical ring resonator 100 may have a top portion 111. The top portion 111 facing away from the substrate 102.

The spatial extent of the ring element 104 in a plane parallel to the surface of the substrate 102 may be described by an outer radius 107 of the ring element 104, see Figure 1a.

Figure 1c illustrates schematically the energy band structure of the formed pn junctions of the ring element 104. Put differently, the pn junctions formed between the p-type core ring and the n-type ring-shaped embedding shell is illustrated. From Figures 1a, 1b and 1c it may be understood that a double vertical pn junction structure is provided, i.e. that a concentric pn junction is formed at the radial inner and outer sides 110, 112 of the core ring 106.

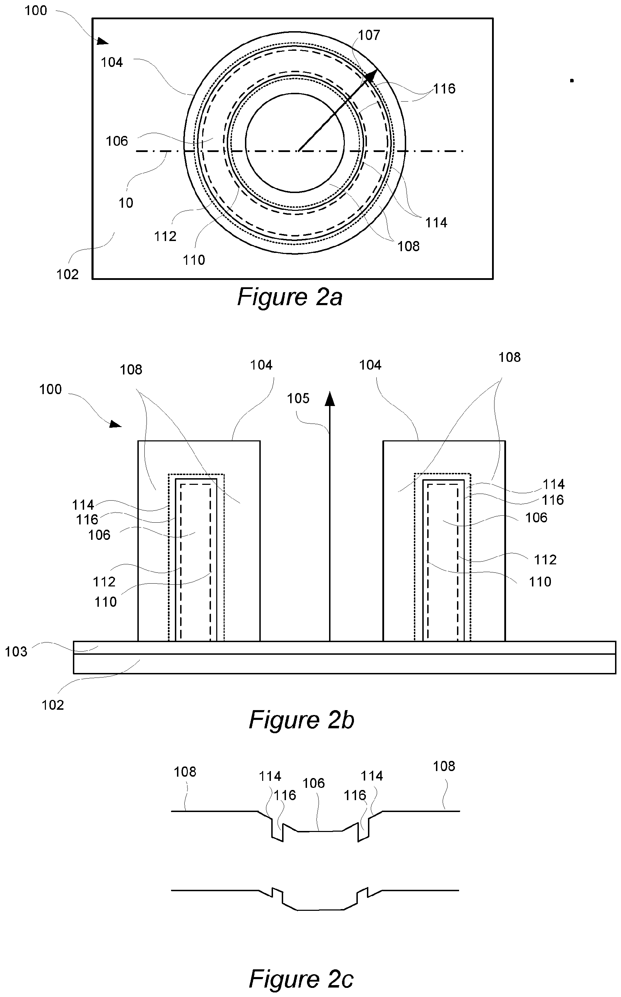

Figure 2a shows schematically a top view of another optical ring resonator according to some examples. Figure 2b shows the same optical ring resonator from a cross sectional view and Figure 2c illustrates schematically a band structure diagram across the radial direction of the ring element.

The optical ring resonator 100 is shown to comprise a substrate 102 and a ring element 104 arranged on the substrate 102. The ring element 104 comprises a core ring 106 having a p-doped GaN crystal structure, and a ring-shaped embedding shell 108 having an n-doped GaN crystal structure, as further described above. The core ring 106 is illustrated by dashed lines for clarity. The ring-shaped embedding shell 108 embeds the core ring 106 both on a radially inward side 110 and a radially outward side 112 thereof.

The ring element 104 is shown to further comprise an intermediate shell 114 arranged in between the core ring 106 and the ring-shaped embedding shell 108, the intermediate shell 114 comprises a quantum well layer 116 made of a semiconductor material having a lower bandgap than GaN. The intermediate shell 114 is illustrated by the dotted lines in Figure 2a and 2b. The quantum well layer 116 is illustrated by the solid lines arranged in between the peripheries of the core ring 106 and the intermediate shell 114.

In Figure 2c an energy band structure diagram along the radial direction of the ring element 104 is schematically illustrated. The diagram illustrates the intermediate layer 114 in which the quantum well layer 116 is arranged.

The intermediate layer may be understood to comprise or be formed by GaN.

The quantum well layer 116 may be made from In(x)Ga(1-x)N, wherein the In content, x, is in a range 0.1 ≤ x ≤ 0.75. The quantum well layer may thereby have a smaller bandgap than GaN, i.e. a smaller bandgap than the bandgap of the intermediate layer.

The quantum well layer 116 may have a thickness of ≤ 5 nm. An efficient confinement effect may thereby be obtained. This confinement in one dimension may lead to quantized energy levels, creating a potential well in which the charge carriers are restricted to move. The splitting of the energy levels may be adjusted by changing the thickness and/or composition of the quantum well layer.

The intermediate layer 114 of Figures 2a to 2c is illustrated as a single quantum well layer 116. According to other examples, the intermediate layer 114 may comprise a plurality of quantum well layers. The individual quantum wells of the plurality of quantum wells may be separated by GaN layers. The plurality of quantum well layers may be arranged in a sequence inside the intermediate layer.

The plurality of quantum well layers may have the same thickness and the same composition.

According to other examples, one or more of the quantum well layers of the plurality of quantum well layers may have a thickness and/or a composition that is different to the other quantum wells of the plurality of quantum well layers.

The plurality of quantum well layers may be referred to as a multi quantum well structure.

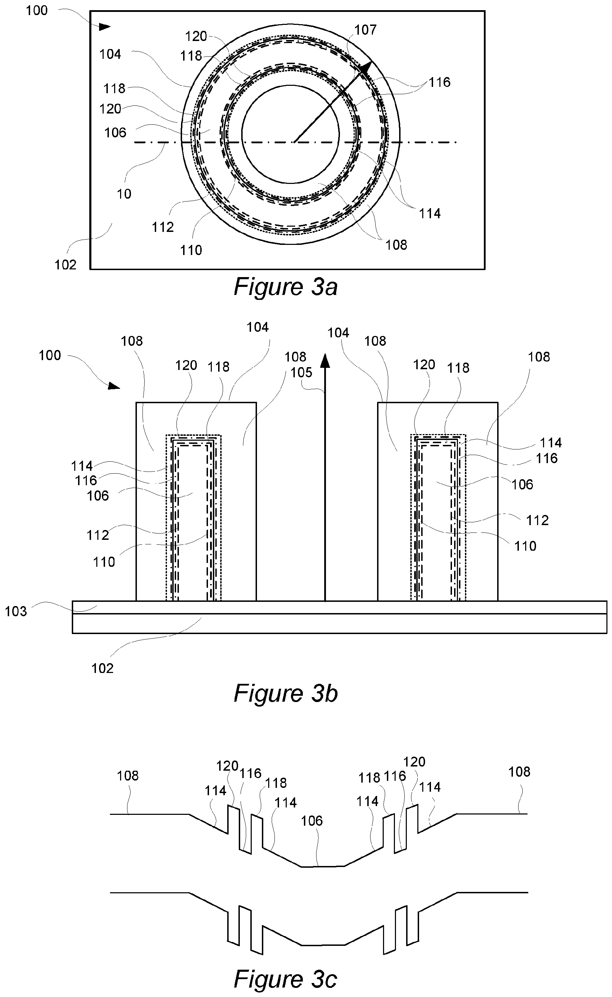

Figure 3a shows schematically a top view of yet another optical ring resonator according to some examples. Figure 3b shows the same optical ring resonator from a cross sectional view and Figure 3c illustrates schematically an energy band structure diagram across the radial direction of the ring element.

The optical ring resonator 100 of Figures 3a to 3c are shown to comprise the features of the optical ring resonator 100 described above. The intermediate shell 114 is shown to further comprise a first and a second barrier layer 118,120 arranged on opposite sides of the quantum well layer 116 in a radial extension of the ring element 104. The first and the second barrier layers 118,120 are illustrated as dash-dash-dotted lines arranged on opposite sides of the quantum well layer 116.

The first and second barrier layers 118,120 may be made from an AI(y)Ga(1-y)N, wherein the Al content, y, is in a range of 0.1 ≤ y ≤ 1.

The first and the second barrier layers 118,120 may thereby have a larger bandgap than the quantum well layer 116 and the intermediate layer 114.

A multi quantum well structure may further comprise a plurality of barrier layers arranged at opposite sides of the respective quantum wells.

In Figure 3c an energy band structure diagram along the radial direction of the ring element 104 is schematically illustrated. The diagram illustrates the intermediate layer 114 in which the quantum well layer 116 and the barrier layers 118,120 are arranged.

The first and second barrier layers 118,120 may have a thickness of ≤ 10 nm. The energy levels of the quantum wells formed may thereby be tuned.

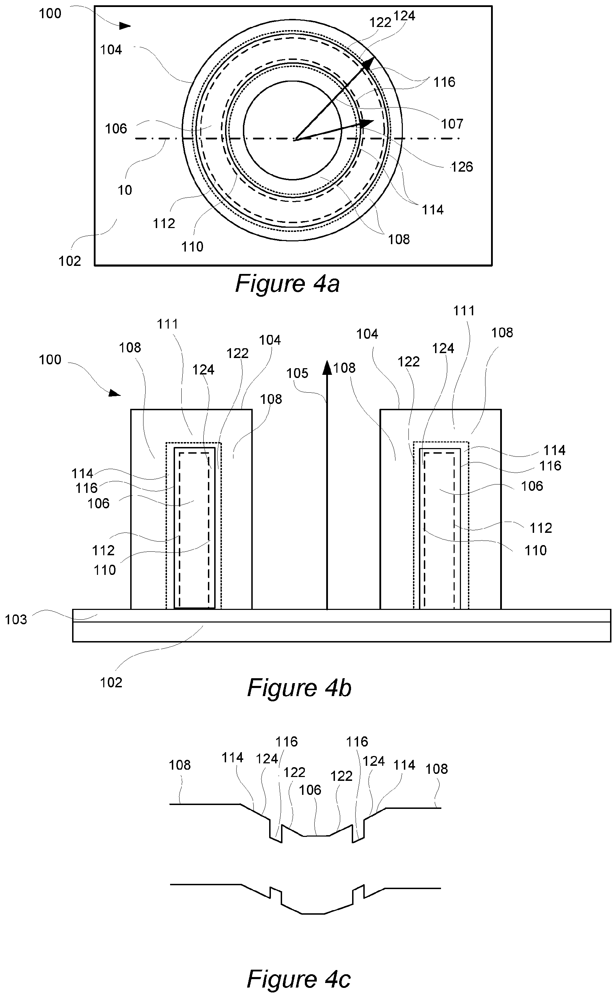

Figure 4 shows schematically a top view of yet another optical ring resonator according to some examples. Figure 4b shows the same optical ring resonator from a cross sectional view and Figure 4c illustrates schematically a band structure diagram across the radial direction of the ring element.

In Figures 4a to 4c it is illustrated that the intermediate shell 114 may further comprise first and second intrinsic layers 122, 124. The first and second intrinsic layers 122, 124 are arranged on opposite sides of the quantum well layer 116 in a radial extension of the ring element 104. The first and second intrinsic layers 122, 124 form the outermost layers of the intermediate shell 114. The first and second intrinsic layers 122,124 are made by undoped GaN.

The first and the second intrinsic layers may be understood to form the intermediate shell.

The skilled person understands that the optical ring resonator as illustrated in Figure 4a to 4c may further comprise features as described in relation to Figures 1 to 3. For clarity, only a quantum well 116 and the intrinsic layers 122, 124 are illustrated in this example. Put differently, the optical ring resonator 100 may further comprise barrier layers and/or a plurality of quantum wells as described above.

A centrum radius 126 of the ring element 104 as described above may be 1-10 micrometer, see Figure 4a.

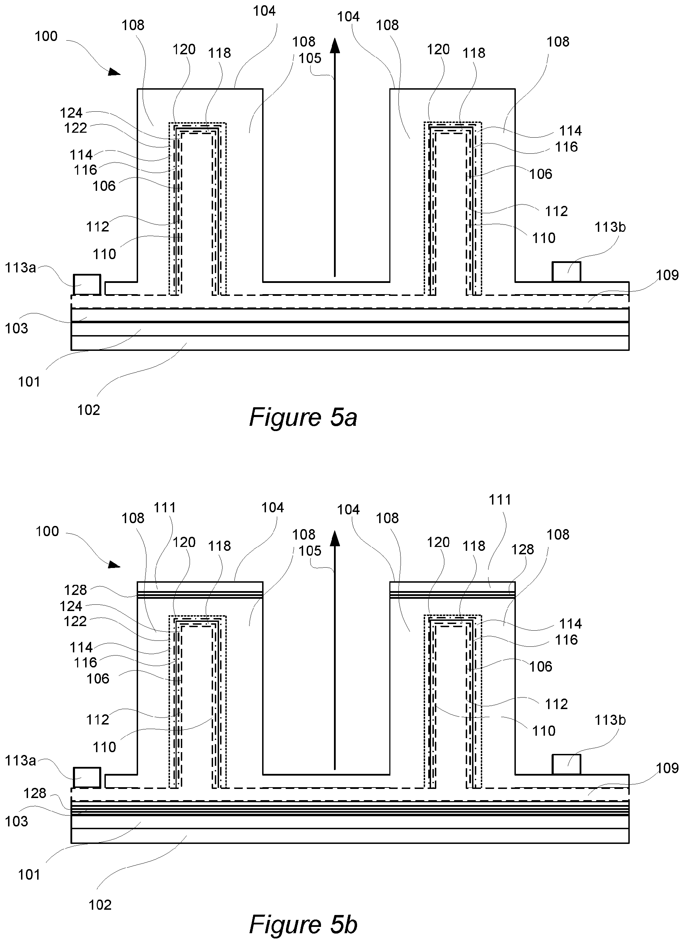

Figure 5a illustrates an optical ring oscillator according to some examples.

The optical ring resonator 100 comprises a substrate 102, a ring element 104, a core ring 106 and a ring-shaped embedding shell 108 as described above. The ring element 104 is arranged on the substrate 102. Th substrate 102 may comprise an AIN layer 101. A GaN layer 103 may further be arranged on the AIN layer 101. The layers 101 and 103 may be epitaxially grown.

The ring element 104 comprises a core ring 106 having a p-doped GaN crystal structure. The core ring 106 may be supported by a base layer 109. The base layer 109 may be a p-doped GaN layer formed on the substrate 102 or on the GaN layer 103. The base layer 109 and the core ring 106 may form crystal structure. Put differently, the core ring 106 may be epitaxially grown on the base layer 109.

The ring-shaped embedding shell 108 has a n-doped GaN crystal structure. The ring-shaped embedding shell 108 embeds the core ring 106. The ring-shaped embedding shell 106 may further extend and cover a portion of the p-doped GaN base layer 101.

The optical ring oscillator 100 may further comprise electrodes 113a, 113b. The electrodes 113a, 113b may be in electrical contact with the respective p- and n-doped GaN crystal structures such that the pn junction is forward or reverse biased. The electrodes 113a, 113b may be metallic electrodes.

The ring element 104 of Figure 5a further comprises an intermediate shell 114 arranged in between the core ring 106 and the ring-shaped embedding shell 108. The intermediate shell 114 comprises a quantum well layer 116 made of a semiconductor material having a lower bandgap than GaN.

The intermediate shell 114 further comprises a first and a second barrier layer 118,120 arranged on opposite sides of the quantum well layer 116 in a radial extension of the ring element 104.

The intermediate shell 114 further comprises first and second intrinsic layers 122, 124 arranged on opposite sides of the quantum well layer 116 in a radial extension of the ring element 104 and forming outermost layers of the intermediate shell 114, wherein the first and second intrinsic layers 122,124 are made by undoped GaN.

By way of example, the p-doped GaN may have a doping of 10x19 cm-3. The n-doped GaN may have a doping of 5x18 cm-3. The n-doping may be made by Si.

The optical ring element 100 of Figure 5, may comprise a multilayer quantum well structure as described above. The quantum well layers of the multilayer may be sandwiched in between barrier layers.

Figure 5b illustrates an optical ring oscillator according to some examples. The optical ring element may comprise the features as described in relation to Figure 5a. As further illustrated in Figure 5b, the optical ring resonator 100 further comprises a superlattice structure 128. The superlattice structure 128 comprises alternating layers of AlGaN and GaN.

The superlattice structure 128 may be arranged on a top portion 111 of the optical ring resonator 100. The superlattice 128 may extend in a plane parallel to the substrate 102. Alternately or in combination, the superlattice structure 128 may be arranged between the substrate 102 and the ring element 104, see Figure 5b.

The superlattice structure 128 may form a Bragg reflector or distributed Bragg reflector.

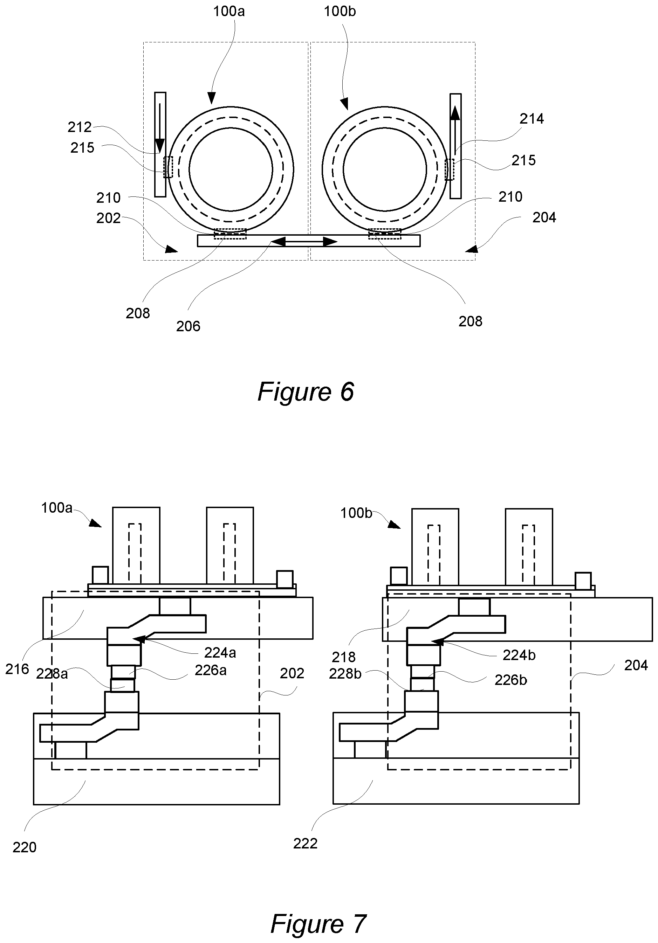

Figure 6 illustrates an optical interconnect system according to some examples. The optical interconnect system 200 comprises a first optical ring resonator 100a. The first optical ring resonator 100a forms part of a first electrical circuit 202.

The optical interconnect system 200 also comprises a second optical ring resonator 100b. The second optical ring resonator 100b forms part of a second electrical circuit 204.

The first and the second optical ring resonators 100a, 100b may each comprise the features of the optical ring structures 100 described above.

The optical interconnect system 200 further comprises a bus waveguide 206 having a GaN semiconductor core for transmission of light. The bus waveguide 206 comprises coupling regions 208 for forming an optical connection with the first and second optical ring resonators 100a, 100b, respectively. The optical connection may be formed by evanescent coupling. The GaN semiconductor core allows for efficient light propagation between the first and second electrical circuits for transmitting information therebetween. The bus waveguide 206 may be understood as an optical waveguide. The optical waveguide may be a rectangular waveguide.

The optical interconnect system 200 may further comprise a respective grating coupler 210 arranged at the respective coupling regions 208.

The distance between a periphery of the first and second optical ring resonators 100a,100b, respectively, and the bus waveguide 206 may be less than 1 micron.

The bus waveguide 206 may be arranged to abut the outer periphery of the first and second optical ring resonators 100a,100b respectively.

The first electrical circuit 202 may comprise a transmitter 212 configured to generate a modulated light signal based on an electrical input signal and injecting the modulated light signal into the first optical ring resonator 100a.

To this end, the second electrical circuit 204 may comprise a receiver 214 configured to receive a modulated light signal from the second optical ring resonator 100b and based thereon generate an electrical output signal.

The transmitter 212 and the receiver 214 are illustrated in Figure 6 to be connected to the respective optical ring resonators 100a, 110b via evanescent coupling, see the dotted areas 215. According to other examples, the transmitter and the receiver may be physically connected to the respective optical ring resonators.

Figure 7 illustrates an optical interconnect system according to some examples. A first optical ring resonator 100a is arranged on a first semiconductor die 216 and a second optical ring resonator 100b is arranged on a second semiconductor die 218.

A portion of a first electrical circuit 202 is further arranged on a third semiconductor die 220 and a portion of a second electrical circuit 204 is arranged on a fourth semiconductor die 222. The first semiconductor die 216 is electrically connected to the third semiconductor die 220 for forming the first electrical circuit 202. The second semiconductor die 218 is electrically connected to the fourth semiconductor die 222 for forming the second electrical circuit 204.

The first semiconductor die 216 may be electrically connected to the third semiconductor die 220 via a redistribution metal layer 224a and an under bump 226a disposed on the first semiconductor die 216, and a solder joint 228a between the third semiconductor die and the under bump 226a.

The second semiconductor die 218 may be electrically connected to the fourth semiconductor die 222 via a redistribution metal layer 224b and an under bump 226b disposed on the second semiconductor die 218, and a solder joint 228b between the fourth semiconductor die 222 and the under bump 226b.

The third and/or the forth semiconductor die 220, 222 may comprise a central processing unit, CPU.

The person skilled in the art realizes that the present disclosure is not limited to the preferred examples described above. The person skilled in the art further realizes that modifications and variations are possible within the scope of the appended claims. Additionally, variations to the disclosed examples can be understood and effected by the skilled person in practicing the claimed disclosure, from a study of the drawings, the disclosure, and the appended claims.

## Claims

1. An optical ring resonator (100) comprising:
a substrate (102);
a ring element (104) arranged on the substrate (102), the ring element (104) comprising:
a core ring (106) having a p-doped GaN crystal structure, and
a ring-shaped embedding shell (108) having a n-doped GaN crystal structure, the ring-shaped embedding shell (108) embedding the core ring (106) both on a radially inward side (110) and a radially outward side (112) thereof.

2. The optical ring resonator (100) according to claim 1, wherein the ring element (104) further comprising an intermediate shell (114) arranged in between the core ring (106) and the ring-shaped embedding shell (108), the intermediate shell (114) comprising a quantum well layer (116) made of a semiconductor material having a lower bandgap than GaN.

3. The optical ring resonator (100) according to claim 1 or 2, wherein the quantum well layer (116) is made from In(x)Ga(1-x)N, wherein the In content, x, is in a range 0.1 ≤ x ≤ 0.75.

4. The optical ring resonator (100) according to claim 3, wherein the quantum well layer (116) has a thickness of ≤ 5 nm.

5. The optical ring resonator (100) according to any one of claims 2-4, wherein the intermediate shell (114) further comprises a first and a second barrier layer (118,120) arranged on opposite sides of the quantum well layer (116) in a radial extension of the ring element (104).

6. The optical ring resonator (100) according to claim 5, wherein the first and second barrier layers (118,120) are made from an AI(y)Ga(1-y)N, wherein the Al content, y, is in a range of 0.1 ≤ y ≤ 1.

7. The optical ring resonator (100) according to claim 5 or 6, wherein the first and second barrier layers (118,120) has a thickness of ≤ 10 nm.

8. The optical ring resonator (100) according to any one of claims 2-7, wherein the intermediate shell (114) further comprises first and second intrinsic layers (122, 124) arranged on opposite sides of the quantum well layer (116) in a radial extension of the ring element (104) and forming outermost layers of the intermediate shell (114), wherein the first and second intrinsic layers (122,124) are made by an undoped GaN.

9. The optical ring resonator (100) according to any one of claims 1-8, wherein a centrum radius (126) of the ring element (104) is 1-10 micrometer.

10. The optical ring resonator (100) according to any one of claims 1-9, further comprising a superlattice structure (128) comprising alternating layers of AlGaN and GaN.

11. An optical interconnect system (200) comprising:
a first optical ring resonator (100a) according to any one of claims 1-10, the first optical ring resonator (100a) forming part of a first electrical circuit (202);
a second optical ring resonator (100b) according to any one of claims 1-10, the second optical ring resonator (100b) forming part of a second electrical circuit (204); and
a bus waveguide (206) having a GaN semiconductor core for transmission of light, the bus waveguide (206) comprising coupling regions (208) for forming an optical connection with the first and second optical ring resonators (100a,100b), respectively.

12. The optical interconnect system (200) according to claim 11, further comprising a respective grating coupler (210) arranged at the respective coupling regions (208).

13. The optical interconnect system (200), according to claim 11 or 12, wherein a distance between a periphery of the first and second optical ring resonators (100a,100b), respectively, and the bus waveguide (206) is less than 1 micron.

14. The optical interconnect system (200) according to any one of claims 11-13,
wherein the first electrical circuit (202) comprises a transmitter (212) configured to generate a modulated light signal based on an electrical input signal and injecting the modulated light signal into the first optical ring resonator (100a),
wherein the second electrical circuit (204) comprises a receiver (214) configured to receive a modulated light signal from the second optical ring resonator (100b) and based thereon generate an electrical output signal.

15. The optical interconnect system (200) according to any one of claims 11-14, wherein:
the first optical ring resonator (100a) is arranged on a first semiconductor die (216),
the second optical ring resonator (100b) is arranged on a second semiconductor die (218),
a portion of the first electrical circuit (202) is arranged on a third semiconductor die (220),
a portion of the second electrical circuit (204) is arranged on a fourth semiconductor die (222),
the first semiconductor die (216) is electrically connected to the third semiconductor die (220) for forming the first electrical circuit (202), and
the second semiconductor die (218) is electrically connected to the fourth semiconductor die (222) for forming the second electrical circuit (204).
